# EUROPEAN PATENT APPLICATION

(11) **EP 1 254 742 A2**
(43) Date of publication of application: **06.11.2002**
(21) Application number: 02005540.6
(22) Date of filing: 11.03.2002
(51) Int. Cl.: B24B 37/04, B24B 1/00

(54) **Thermal mechanical planarization in intergrated circuits**

(30) Priority: 04.05.2001 US 848997
(71) Applicant: Chartered Semiconductor Manufacturing ,Ltd., Singapore 738406 (SG)
(72) Inventor: Leong, Lup San, 733893 Singapore (SG)
(74) Representative: Kirschner, Klaus Dieter, Dipl.-Phys.

(57) **Abstract**

A method and equipment (10,50) is provided for planarization of ILD layers on a semiconductor wafer (14). The method includes providing an oven (12) having a wafer holder (26) therein, placing the semiconductor wafer (14) on the wafer holder (26), and simultaneously applying mechanical pressure and heat to the ILD layer on the semiconductor wafer (14) using a mechanical device (16,56).

## Description

The present invention relates generally to manufacture of semiconductor integrated circuit devices, and more specifically to an apparatus and method for planarizing interlayer and intralayer spin-on low dielectric constant layers.

Integrated circuits (ICs) are made up of millions of active and passive devices such as transistors, capacitors, and resistors. These devices are initially isolated from one another but are later connected together to form functional circuits through interconnect structures. The quality of the interconnect structure drastically affects the performance and reliability of the fabricated ICs.

Conventional interconnect structures employ one or more metal layers. Each metal layer is typically made from aluminum, titanium, tantalum, tungsten, or alloys thereof. Interlevel and intralevel dielectrics (ILD) layers are used to electrically insulate active elements and different interconnect wires from each other. The electrical connections between different interconnect levels are made through vias that are formed in the ILD layers.

The ILD layers generally employ low dielectric constant (low-k) materials as insulators in IC interconnect because these low-k materials reduce the interconnect capacitance, which increase the signal propagation speed while reducing cross-talk noise and power dissipation in the interconnect.

The complexity of present-day integrated circuits requires that the devices on silicon wafer substrates shrink to sub-micron dimensions and the circuit density increases to several million transistors per die. In order to achieve these requirements, smaller and smaller feature sizes are needed for both width and spacing of features. Furthermore, as wiring densities in ICs increase, multiple wiring levels are required to achieve interconnection of the devices, and planarization of the ILDs becomes a critical step in the fabrication process. Planarized dielectric layers must be formed between metal layers of an integrated circuit in order to achieve good metallization step coverage of the interconnect metal lines. Also, planarization is necessary to facilitate masking and etching operations. A planarized surface provides a constant depth of focus across the surface for exposing patterns in lithographic layers.

However, the planarization of low-k materials as ILD layers still needs to be developed for accommodating the low-k material when forming the interconnect. Processes such as CMP (Chemical Mechanical Polishing) and plasma etchback have been used, but such processes suffer from the disadvantages of high expense, low product throughput, and great process complexity.

A method of planarization of ILD layers without the disadvantages has been long sought but has long eluded those skilled in the art.

The present invention provides a method for planarization of ILD layers on a semiconductor wafer. The method includes providing an oven having a wafer holder therein, placing the semiconductor wafer on the wafer holder, and simultaneously applying mechanical pressure and heat to the ILD layer on the semiconductor wafer using a mechanical device. An inexpensive, high product throughput, and simple process is achieved.

The present invention further provides apparatus for planarization of ILD layers on a semiconductor wafer. The apparatus includes an oven, a wafer holder in the oven, and a mechanical device for simultaneously applying mechanical pressure and heat to the ILD layer on the semiconductor wafer. An inexpensive, high product throughput, and simple process apparatus for ILD layer planarization is achieved.

The above and additional advantages of the present invention will become apparent to those skilled in the art from a reading of the following detailed description when taken in conjunction with the accompanying drawings.

FIG. 1 is a plan view of an embodiment of the system in accordance with the present invention;
FIG. 2 is a side view of Fig. 1 of the system in accordance with the present invention;
FIG. 3 is a plan view of another embodiment of the system in accordance with the present invention; and
FIG. 4 is a side view of Fig. 3 of the system in accordance with the present invention. Referring now to FIG. 1, therein is shown a plan view of a thermal-mechanical planarization system 10 in accordance with the present invention. In the system 10 are shown a oven 12 which contains a semiconductor wafer 14 disposed under a top plate 16 having a thermally controlled contact surface.

The top plate 16 has its temperature monitored by an infrared scattering detector and circuitry 18 as it rotates in the direction indicated by an arrow 20. An arrow 22 indicates the direction of rotation of the semiconductor wafer 14, which is in the same direction as the top plate 16 but having a certain degree of relative motion with respect thereto. There is a speed differential between the top plate 16 and the semiconductor wafer 14 to allow lateral movement of the top plate 16, as will later be described.

The infrared scattering detector and circuitry 18 detects infrared radiation indicated by the arrow 24 from the top plate 16 to allow monitoring of the top plate 16 and, if desired, controlled through a heating element (not shown) associated with the top plate 16.

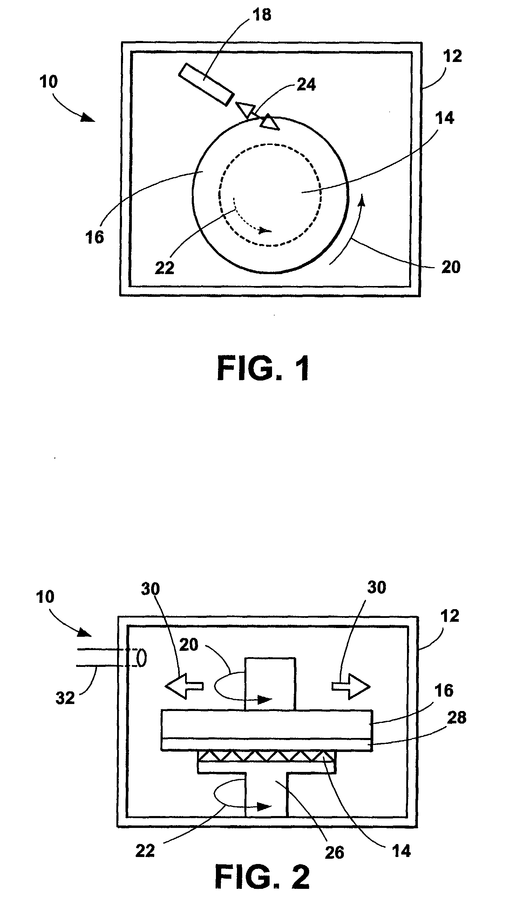

Referring now to FIG. 2, therein is shown a side view of the system 10 in accordance with the present invention. The semiconductor wafer 14 is shown mounted on a rotating wafer holder 26, which rotates in the direction indicated by the arrow 22. A thermally conducting non-stick surface 28 is shown under the top plate 16 in contact with the semiconductor wafer 14. As the top plate 16 rotates in the direction indicated by the arrow 20, it traverses the semiconductor wafer 14 along the horizontal plane in the direction indicated by a pair of arrows 30.

The thermally conducting non-stick surface 28 may be made to be consumed during the planarization of the low dielectric contant (low-k) ILD layer planarization to reduce friction and improve the surface characteristics of the ILD layer.

During the planarization process, vertical pressure is applied to the top plate 16 as it rotates and traverses relative to the semiconductor wafer 14. At the same time, the semiconductor wafer 14 is heated to a temperature below the hard-baked temperature of the spin-on low dielectric constant material (between 100°C to 400°C, depending on the chemical properties of the material) which causes the material to emit various volatile gases which are exhausted from the oven 12 through an exhaust 32.

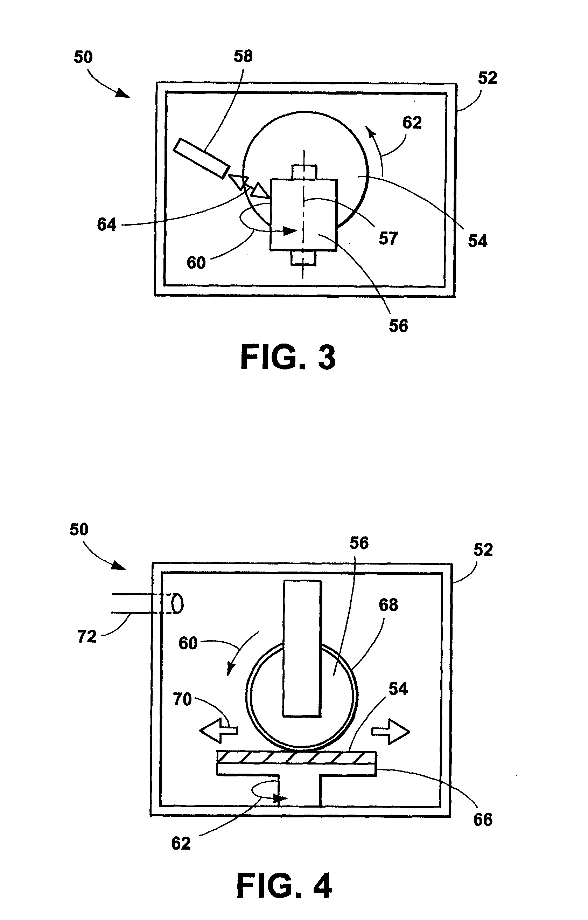

Referring now to FIG. 3, therein is shown a plan view of a thermal-mechanical planarization system 50 in accordance with the present invention. In the system 50 are shown a oven 52 which contains a semiconductor wafer 54 disposed under a roller 56, which rotates about an axis 57, having a thermally controlled contact surface.

The roller 56 has its temperature monitored by an infrared scattering detector and circuitry 58 as it rotates in the directions indicated by the arrow 60. An arrow 62 indicates the direction of rotation of the semiconductor wafer 54, which is in the same direction as the roller 56, which rotates about an axis 57. There is a speed differential between the roller 56, which rotates about the axis 57, and the semiconductor wafer 54 to allow lateral relative movement of the roller 56 as will later be described.

The infrared scattering detector and circuitry 18 detects infrared radiation 64 being given out by the roller 56, as it rotates about the axis 57, to allow monitoring of the roller 56 and, if desired, controls the temperature through a heating element (not shown) associated with the roller 56.

Referring now to FIG. 4, therein is shown a side view of the system 50 in accordance with the present invention. The wafer 54 is shown mounted on a rotating wafer holder 66, which rotates in the direction indicated by the arrow 62. The roller 56 has a termally conducting non-stick surface 68, which rotates in contact with the semiconductor wafer 54. As the roller 56, which rotates about the axis 57, rotates in the direction indicated by the arrow 60, it laterally traverses along the horizontal plane in the direction indicated by the arrows 70.

The thermally conducting non-stick surface 68 may be made to be consumed during the planarization of the low dielectric contant (low-k) ILD layer planarization.

During the planarization process, vertical pressure is applied to the roller 56, which rotates about an axis 57, as it rotates and traverses relative to the semiconductor wafer 54. At the same time, the semiconductor wafer 54 is heated to a temperature below the hard-baked temperature of the spin-on low dielectric constant material (between 100 °C to 400 °C, depending on the chemical properties of the material) which causes the material to emit various volatile gases which are exhausted from the oven 52 through an exhaust 72.

In the present invention, the semiconductor wafer 14 or 54 is placed on its respective wafer holder 26 or 66 and is held in place by a vacuum. The wafer holder 26 or 66 is then rotated at a relatively high speed and the low-k dielectric material is deposited on the center of the semiconductor wafer 14 or 54. Centrifugal forces causes the low-k dielectric material to spread out to a relatively uniform, but not planar, thickness.

After being spun on, the low-k dielectric material is subject to a soft bake (at a temperature below 100°C, depending on the chemical properties of the material).

After the soft bake, the low-k dielectric material on the semiconductor wafer 14 or 54 is heated to below the hard bake temperature of the low-k dielectric material (between 100°C to 400°C, depending on the chemical properties of the material). A thermal mechanical planarization process is then applied to cause reflow of the low-k dielectric material. This thermal mechanical planarization is accomplished by the application of thermal energy and mechanical pressure energy. In one embodiment, the semiconductor wafer is subject to thermal energy applied by means of the top plate 16, which is heated, and moved relative to the semiconductor wafer 14. The plate both rotates, as indicated in FIG. 1 by the arrow 20, and traverses, as indicated in FIG. 2 by the arrow 30.

In another embodiment, the semiconductor wafer 54 is subject to the mechanical pressure of the roller 56, which is heated to provide theraml energy. The roller 56 rotates in the direction indicated by the arrow 60 in FIG. 3 and also traverses as indicated by the arrow 70 in FIG. 4.

While the thermal mechanical planarization occurs, volatile materials from the low-k dielectric material are evacuated from the inside of the respective oven 12 or 52 by respective exhaust 32 and 72. It will be noted that the top plate 16 and the roller 56 are covered by respective thermally conducting non-stick surfaces 28 and 68, which could be designed to be consumed so as to reduce friction.

The infrared detectors and circuitry 18 and 58 respectively monitor the top plate 16 and the roller 56 to monitor their temperatures (in the range of 100 °C to 400 °C depending on the chemical composition of the low-k dielectric material). The thermally conductive non-stick surfaces 28 and 68 may be made from material such as carbon-grafted Teflontm or comparable materials. The infrared detectors and circuitry 18 and 58 can be connected for phase-lock loop feedback to control the temperatures of the various heatable components.

As would be evident to increase throughput, more than one wafer holder and ancillary thermal-mechanical planarization units may be used.

While the invention has been described in conjunction with a specific best mode, it is to be understood that many alternatives, modifications, and variations will be apparent to those skilled in the art in light of the aforegoing description. Accordingly, it is intended to embrace all such alternatives, modifications, and variations which fall within the scope of the included claims. All matters hither-to-fore set forth herein or shown in the accompanying drawings are to be interpreted in an illustrative and non-limiting sense.

## Claims

1. A method for planarization of ILD layers on a semiconductor wafer (14) comprising:
providing an oven (12) having a wafer holder (26) provided therein ;
placing the semiconductor wafer (14) on the wafer holder (26);
applying mechanical pressure to the ILD layer on the semiconductor wafer (14) using a mechanical device (16,56); and
applying heat to the ILD layer on the semiconductor wafer (14) using the mechanical device (16,56) simultaneously with the applying the mechanical pressure.

2. The method as claimed in claim 1 wherein:
applying the mechanical pressure includes providing relative motion between the mechanical device (16,56) and the ILD layer on the semiconductor wafer (14) to assist in planarization.

3. The method as claimed in claim 1 wherein:
applying the mechanical pressure includes providing non-sticking motion and transferring heat between the mechanical device (16,56) and the ILD layer on the semiconductor wafer (14) to assist in planarization.

4. The method as claimed in claim 1 wherein:
applying the heat includes sensing and controlling the temperature of the mechanical device (16,56).

5. The method as claimed in claim 1 wherein:
applying the mechanical pressure uses a top plate as part of the mechanical device (16).

6. The method as claimed in claim 1 wherein:
applying the mechanical pressure uses a roller as part of the mechanical device (56).

7. An apparatus for planarization of ILD layers on a semiconductor wafer (14) comprising:
an oven (12);
a wafer holder (26) provided in the oven (12); and
a mechanical device (16,56) for simultaneously applying mechanical pressure and heat to the ILD layer on the semiconductor wafer (14).

8. The apparatus as claimed in claim 7 wherein:
the mechanical device (16,56) includes a mechanism for providing relative motion between the mechanical device (16,56) and the ILD layer on the semiconductor wafer (14) to assist in planarization.

9. The apparatus as claimed in claim 7 wherein:
the mechanical device (16,56) includes a mechanism for providing non-sticking motion and transferring heat between the mechanical device (16,56) and the ILD layer on the semiconductor wafer (14) to assist in planarization.

10. The apparatus as claimed in claim 7 wherein:
the mechanical device (16,56) includes circuitry (18,58) for sensing and controlling the temperature of the mechanical device (16,56).

11. The apparatus as claimed in claim 7 wherein:
the mechanical device (16) includes a top plate for applying mechanical pressure.

12. The apparatus as claimed in claim 7 wherein:
the mechanical device (56) includes a roller for applying mechanical pressure.
